# EUROPEAN PATENT SPECIFICATION

(11) **EP 4 635 000 B1**
(45) Date of publication and mention of the grant of the patent: **28.10.2026**
(21) Application number: 23847923.2
(22) Date of filing: 13.12.2023
(51) Int. Cl.: H10H 20/01, H10H 20/831, H10H 20/84, H10H 20/857

(54) **LIGHTING APPARATUS AND METHOD OF MAKING A LIGHTING APPARATUS**
BELEUCHTUNGSVORRICHTUNG UND VERFAHREN ZUR HERSTELLUNG EINER BELEUCHTUNGSVORRICHTUNG
DISPOSITIF D'ÉCLAIRAGE ET PROCÉDÉ DE FABRICATION D'UN DISPOSITIF D'ÉCLAIRAGE

(30) Priority: 15.12.2022 US 202263432981 P
(43) Date of publication of application: 22.10.2025
(73) Proprietor: Lumileds LLC, San Jose, CA 95131 (US)
(72) Inventor: MONESTIER, Florent Gregoire, 5652 AB Eindhoven (NL)
(74) Representative: Beckord & Niedlich Patentanwälte PartG mbB
(86) International application number: PCT/US2023/083816
(87) International publication number: WO 2024/129849

(56) References cited:
- EP-A1- 3 346 511
- KR-A- 20180 017 448

## Description

### TECHNICAL FIELD

The present invention relates to a lighting apparatus and a method of making a lighting apparatus. The light-emitting apparatus is configured to control a shape of a luminance emitted therefrom. The shape is controlled through pad size and layer thickness.

### BACKGROUND

Analysis of some automotive system optics suggests that a shaped surface luminance can be desirable. The surface luminance is variable depending on the application, such as where the center is peaked or with a gradient form one side to another side. The surface luminance that has the best system optics efficiency is indicated by a system optics figure of merit (FOM). For example, efficacy of system optics with a total internal reflection (TIR) lens will be higher for a light emitting diode (LED) die with surface luminance concentrated in the center. On the other hand, efficacy of system optics with a reflector, will be higher for an LED die having one side with peak luminance and high contrast.

KR 20180017448 A discloses a lighting apparatus and a method of making a lighting apparatus.

### SUMMARY

The present invention provides a lighting apparatus according to independent claim 1 and a method of making a lighting apparatus according to independent claim 14.

### BRIEF DESCRIPTION OF THE DRAWINGS

The figures show various views of an apparatus, system, or method, including a control system that can alter light emerging from one or more light emitting diodes (LEDs), in accordance with some embodiments. The terms "front," "rear," "top," "side," and other directional terms are used merely for convenience in describing the apparatuses and systems and other elements and should not be construed as limiting in any way.
FIGS. 1 and 2 illustrate, by way of example, diagrams of embodiments of respective n-via architectures to supplying a non-uniform current density.
FIG. 3 illustrates, by way of example, a diagram of an embodiment of various operations in forming an LED die with an edge shift luminance profile.
FIG. 4 illustrates, by way of example, a current density distribution heat map from a device formed using a prior technique for edge shift luminance.
FIG. 5 illustrates, by way of example, a current density distribution heat map from a device formed using the method illustrated in FIG. 3.
FIG. 6 illustrates, by way of example, a diagram of an embodiment of various operations in forming an LED die with a center peak luminance profile.
FIG. 7 illustrates, by way of example, a current density distribution heat map from a device formed using a method illustrated herein.
FIG. 8 illustrates, by way of example, a cross-section diagram of an embodiment of the light emitting apparatus of FIG. 3.
FIG. 9 illustrates, by way of example, an exploded view diagram of a portions of the cross-section illustrated in FIG. 8.
FIG. 10 illustrates, by way of example, a diagrammatic explanation of sheet resistance (Rsq).
FIG. 11 illustrates, by way of example, a diagram of an embodiment of a portion of the apparatus of FIG. 3.
FIG. 12 illustrates, by way of example, a luminance diagram of the apparatus of FIG. 3 with a bonding layer with a lower sheet resistance (a thicker bonding layer).
FIG. 13 illustrates, by way of example, a luminance diagram of the apparatus of FIG. 3 with a bonding layer with a sheet resistance of about 0.1 Ohms/sq (a thinner bonding layer).
FIG. 14 illustrates, by way of example, a luminance diagram of the apparatus of FIG. 3 with a bonding layer with a sheet resistance of about 0.15 Ohms/sq (an even thinner bonding layer).
FIG. 15 illustrates, by way of example, a diagram of an embodiment of a portion of an apparatus that includes an opening for the n contact more central to the epitaxial layer than the opening illustrated in FIG. 14.
FIG. 16 illustrates, by way of example, a luminance diagram of the apparatus of FIG. 15 with a bonding layer with a lower sheet resistance (a thicker bonding layer).
FIG. 17 illustrates, by way of example, a luminance diagram of the apparatus of FIG. 15 with a bonding layer with a sheet resistance of about 0.1 Ohms/sq (a thinner bonding layer).
FIG. 18 illustrates, by way of example, a luminance diagram of the apparatus of FIG. 15 with a bonding layer with a sheet resistance of about 0.15 Ohms/sq (an event thinner bonding layer).
FIG. 19 illustrates, by way of example, a cross-section diagram of an embodiment of the apparatus of FIG. 6.
FIG. 20 illustrates, by way of example, a diagram of an embodiment of a method for making an LED device with controlled luminance shape.

### DETAILED DESCRIPTION

Optimal spatial luminance for a high beam with a TIR lens optical system and a low-beam reflector optical system are different. It is desirable to easily achieve different luminance shapes with simple manufacturing variability.

A shaped luminance profile LED die is defined as an LED die in which the luminance averaged over an area equal to at least 10% of the whole light emitting area deviates more than 20% of the mean luminance averaged over the whole light emitting area.

Besides system FOM, another important metric is the flux on road that is mainly determined by light emitting area (LEA) size, mean of current density over the total LEA, and internal quantum efficiency). Flux on the road is the "useful" flux contributing to the comfort of the driver. Only rays that hit the road in front of the driver contribute to flux on road. Rays emitted upward to the direction of sky or the horizon or to the sides are not contributing to flux on road.

As a result, a die with shaped surface luminance will have to combine area with high current density to get a highest FOM and enough area with low current density to get enough flux on road. Current density is the amount of electric current flowing per unit cross-sectional area of a material. IQE is defined as the ratio of the number of electron-hole (e-h) pairs or charge carriers generated to the number of photons absorbed, within an active layer(s) of a device. It is also called the quantum yield and accounts for recombination loss.

As compared with a flat luminance profile, an area with a higher current density will have always lower IQE than an area with uniform current distribution. This is because a relation between an IQE drop and current is strongly nonlinear specially at high current density. As a consequence, IQE of a device with a non-uniform current distribution operated at a high current density will be always lower than device with uniform current density.

Besides FOM gain and flux on road other metrics like a forward voltage (Vf) and efficacy can be important. It is therefore a challenge to find a die design offering the best compromise between system FOM gain, flux on road, Vf, and efficacy drops.

A shaped surface luminance can be obtained by optical altering of the light emitted by the die or by modification of the current distribution or by combining both. If shaped surface luminance is obtained by optical modification, it will always be associated with optical loss needed to deviate from the flat luminance profile. This is, at least in part, why an optical solution is not a preferred solution.

On the other hand, if shaped surface luminance is obtained by modification of a current distribution, a challenge is to find a compromise between FOM gain, flux on the road, Vf, and efficacy penalties.

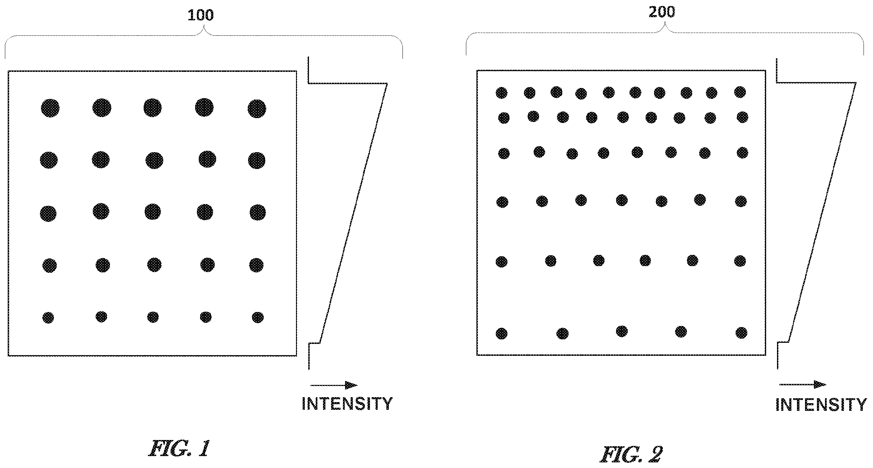

FIGS. 1 and 2 illustrate, by way of example, diagrams of embodiments of respective n-via architectures 100, 200 to supplying a non-uniform current density. The architectures 100, 200 promote current injection with varying current density into different parts of the LED die. This is usually obtained by increasing locally the density of n-Vias or by increasing the size of the n-Vias in the area where peak luminance is desired. The architecture 100 includes an increase in a size of an n-via where higher luminance is desired. The architecture 200 includes an increase in a density of n-vias where higher luminance is desired. The architectures 100, 200 achieve approximately equal luminance profiles through different n-via solutions.

However, drawbacks to the architectures 100, 200 include reducing light emitting area, as no light will be emitted from a larger or added doped semi-conductor etched region coupled to the n-vias. Another drawback is that the architectures 100, 200 require non-periodic patterning (etching or masking) with lower yield. Also, current injection near the edge contact of the die will be limited by the limited contact length (perimeter) compared to n-via perimeter and therefore current density directly near the die border cannot be increased. To solve issues described above, a new method to generate shaped surface luminance profile based on non-uniform current distribution is proposed.

An apparatus in accord with embodiments includes modulated current flow and current injection in a bonding layer. The modulated current flow and current injection is configured to achieve a desired surface luminance profile. The bonding layer is typically a thick metal layer without ohmic loss (current spreading resistance). The bonding layer acts as a redistribution and current spreading layer. The bonding layer offers low contact resistance to doped layers. The bonding layer is usually made of at least 2 parts: a first part for an anode contact and a second part for a cathode contact.

A technique to get the shaped surface luminance profile can include injecting current to an electrically lossy bonding layer only in an area where peak luminance is desired. As a consequence, a low ohmic loss (current spreading resistance) appears between a part of the bonding layer at which the current is injected and another part of the bonding layer. By adjusting a thickness of the bonding layer, it is possible to tune the ohmic losses to the target level of surface luminance variation desired. An advantage of embodiments is that larger n-vias or additional n-vias are not needed. Also, the more complicated manufacturing steps are also no longer needed.

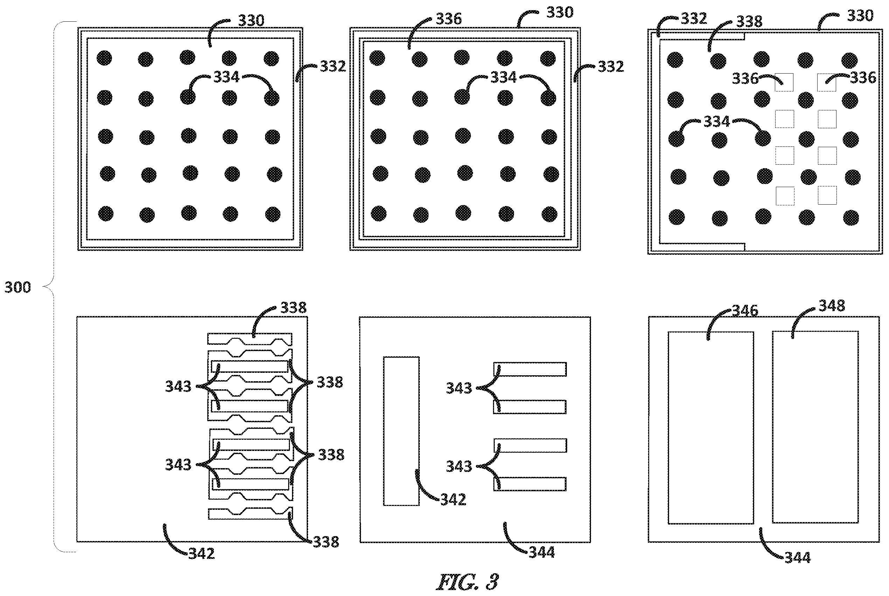

FIG. 3 illustrates, by way of example, a diagram of an embodiment of various operations in forming an LED die 300 with an edge shift luminance profile. A solid, contiguous electrical edge contact 332 is formed on an n-doped semiconductor 330 The edge contact 332 can be formed using standard metallization processes. n-vias 334 are formed on the semiconductor 330. Vias that connect to an n-doped material through a p-doped material are often referred to as n-vias 334. The n-vias 334 can be formed using standard metallization processes. A silver (Ag) material 336 is situated on the p-doped semiconductor around the n-vias 334. The Ag material 336 is in contact with an ITO layer, such as to have ohmic contact with the p-doped semiconductor.

The silver material 336 is situated within a footprint of the edge contact 332. The silver material 336 can be coated or situated using a metallization process.

A dielectric material 338 is formed on the silver material 336 and portions of the edge contact 332. The dielectric material 338 can be a silicon dioxide (SiO2, silicon nitride, or the like). The dielectric material 338 is situated around the n-vias 334. Openings (sometimes called pWindows) are formed in the dielectric material 338 exposing the underlying silver material 336. The dielectric material 338 can be deposited, grown, or the like. The openings can be etched (e.g., laser or chemical), drilled, or the like.

A bonding layer comprising an n-type contact 342 and p-type contacts 343 is formed through a standard metallization process. The bonding layer has a high sheet resistance. High sheet resistance can be defined in terms of resistance per square (Ohms/sq or "Rsq"). A high sheet resistance is greater than (or equal to) 0.06 Ohms/sq or in some instances greater than 0.15 Ohms/sq. For example, Rsq = 0.1 Ω/*sq* could be obtained with 0.265um of Al with bulk resistivity = 2.65 10-8 Ω.m. An Rsq = 0.1 *Ω*/*sq* could be also obtained with 5um of TiW with bulk resistivity = 5 10⁻⁷ Ω.m. Any combination of conductive material providing the right Rsq range is also possible.

The bonding layer is situated over the dielectric material 338. The n-type contacts 342 is electrically connected to the n-vias 334. The p-type contacts 343 fill the openings in the dielectric material 338 through which the silver material 336 is exposed. The n-type contact 342 is electrically isolated from the p-type contacts 343 by openings that expose the dielectric material 338 underneath.

A second dielectric material 344 is formed over the n-type contact 342 and the p-type contacts 343. The second dielectric material 344 is etched or otherwise processed to expose a portion of the n-type contact 342 underneath and the p-type contacts 343 underneath. The contacts 342, 343 are metal, such as copper, silver, aluminum, or other low loss conductive material The second dielectric material 344 can be an electrical insulator mentioned herein. An n-type electrical contact 346 can be formed in electrical contact with the n-type contact 342. A p-type contact 348 can be formed in electrical contact with the p-type contacts 343. The contacts 346, 348 can be made of a same or different material as the contacts 342, 343.

FIG. 3 shows an example die layout of a die with an edge shift luminance profile. As can be seen, the bonding layer (the metal exposed by the opening in the second dielectric material 344 that exposes 342) in this example overlaps only left side and half of top and bottom side of the overall n-type contact 342. Note also that the second dielectric material 344 has an opening for the n-type contact 342 only in the area corresponding to a peak luminance area. An advantage of the method shown in FIG. 3 is that the resulting die surface luminance near the edge of the LEA is not limited by the limited current injection area along the die perimeter.

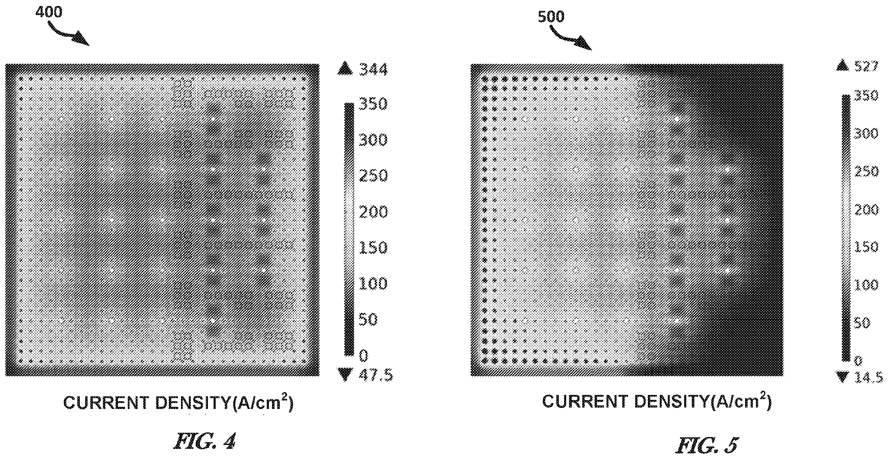

FIG. 4 illustrates, by way of example, a current density distribution heat map 400 from a device formed using a prior technique for edge shift luminance. FIG. 5 illustrates, by way of example, a current density distribution heat map 500 from a device formed using the method illustrated in FIG. 3. As is seen, the current crowding in the edge shifted die is much higher on the left side of the die as shown in FIG. 5. This ESL die has been obtained using a bonding with high sheet resistance. An advantage of this method is that modification of n-vias 334 density or modification of n-via 334 size are not needed. A level of luminance gradient between left and right side and associated Vf increase of the example below can be simply adjusted by modifying the bonding layer thickness.

As ohmic loss are needed only on the n-type contact 342 part of the bonding layer it is possible to have n-type contact 342 and p-type contact 343 parts of the bonding layer with different thicknesses, such as to reduce Vf. Thicknesses of the n-type contact 342 can be lower and a thickness of a p-type contact 343 can be thick enough to have no ohmic losses.

An LED die with two bonding layers can be useful in extreme cases where a luminance profile with a very strong uniformity and very high peak luminance near the die outer edge is desired. In this case, the current is first brought to the outer die edge without loss through a bonding layer with low sheet resistance and then a second bonding layer with high Rsq with current spreading loss from the outer die edge to the center of the die.

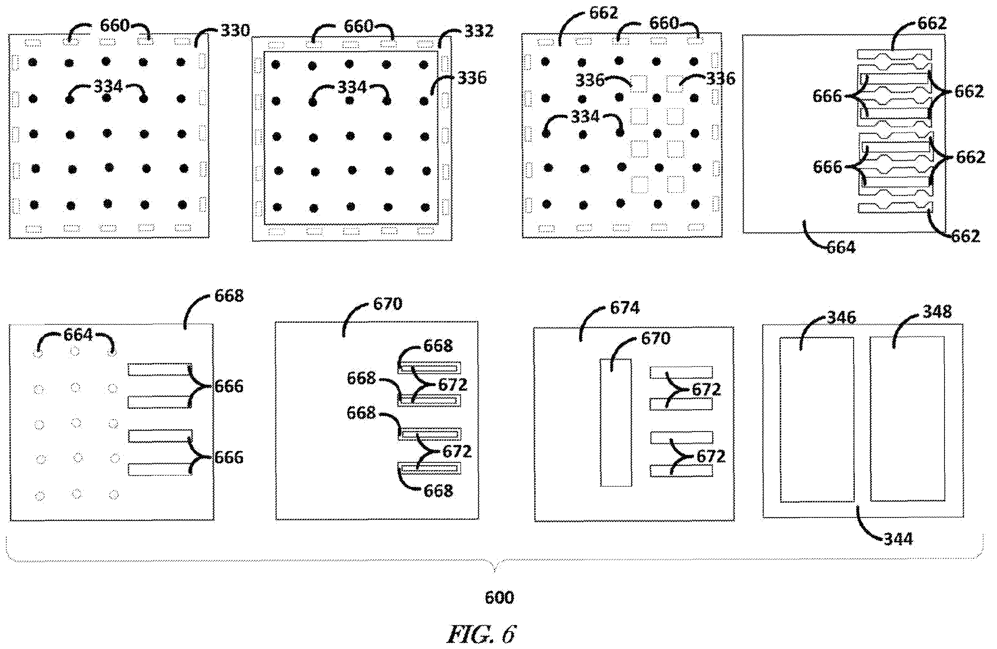

FIG. 6 illustrates, by way of example, a diagram of an embodiment of various operations in forming an LED die 600 with a center peak luminance profile. The LED die 600 is similar to the LED die 300 with the LED die 600 including a segmented electrical edge contact 660 is formed on the substrate 330 as well an additional bonding layer. The edge contact 660 can be formed using standard metallization processes. n-vias 334 are formed on the substrate 330. A silver (Ag) material 336 is situated on the substrate 330 and around the n-vias 334. The silver material 336 is situated within a footprint of the edge contact 660. The silver material 336 can be coated or situated using a metallization process.

A dielectric material 662 (similar to or same as the dielectric material 338) is formed on the silver material 336 and around the contacts 660. The dielectric material 662 is situated around the n-vias 334. Openings are formed in the dielectric material 662 exposing the underlying silver material 336.

A bonding layer with a low sheet resistance (sheet resistance less than the bonding with high sheet resistance) comprising an n-type contact 664 and p-type contacts 666 formed through a standard metallization process. The bonding layer is situated over the dielectric material 662. The n-type contacts 664 (note that n-type contact means a contact electrically connected to an n-doped semiconductor, similarly a p-type contact means a contact electrically connected to a p-doped semiconductor) is electrically connected to the n-vias 334. The p-type contacts 666 fill the openings in the dielectric material 338 through which the silver material 336 is exposed. The n-type contact 664 is electrically isolated from the p-type contacts 666 by openings that expose the dielectric material 662 underneath.

A second dielectric material 668 is formed over the n-type contact 664 and the p-type contacts 666. The second dielectric material 668 is etched or otherwise processed to expose a portion of the n-type contact 664 underneath and the p-type contacts 666 underneath. The contacts 664, 666 are metal, such as copper, silver, aluminum, or other low loss conductive material

A bonding layer with high sheet resistance includes a second n-type contact 670 and second p-type contacts 672 formed through a standard metallization process. The bonding layer with high sheet resistance is situated over the dielectric material 668. The n-type contact 670 is electrically connected to the n-type contact 664 through openings in the dielectric material 668. The p-type contacts 672 fill the openings in the dielectric material 668 through which the p-type contacts 666 are exposed. The n-type contact 670 is electrically isolated from the p-type contacts 672 by openings that expose the dielectric material 668 underneath.

A third dielectric material 674 is formed over the n-type contact 670 and the p-type contacts 672. The third dielectric material 674 is etched or otherwise processed to expose a portion of the n-type contact 670 underneath and the p-type contacts 672 underneath. The contacts 670, 672 are metal, such as copper, silver, aluminum, or other low loss conductive material.

An n-type electrical contact 346 can be formed in electrical contact with the n-type contact 670. A p-type contact 348 can be formed in electrical contact with the p-type contacts 672.

In a case in which a targeted balance of current between different areas of the die could not be reached with one bonding layer (e.g., where a center peak luminance profile die is desired), two bonding layers with different thicknesses can be used. The bonding layers can be separated by a dielectric layer 668 with some openings formed there. The bonding layer comprising the n-type contact 664 can be used to shape the luminance of the light emitted from the apparatus 600. The bonding layer comprising the n-type contact 664 is thin enough to have ohmic loss.

The dielectric layer 668 can have uniformly distributed openings that are used to inject current to the bonding layer comprising the n-type contact 670 can be used to bring the current to the n contact edge area situated on the outer border of the die without ohmic loss. The bonding layer including the n-type contact 670 will have a higher thickness that will not induce ohmic loss between the injection area and other parts.

The dielectric layer 674 connects the bonding layer comprising the n-type contact 670 to the electrical contact pads 346, 348. The dielectric layer 674 has an opening only near the peak current area to promote current injection in the peak current area.

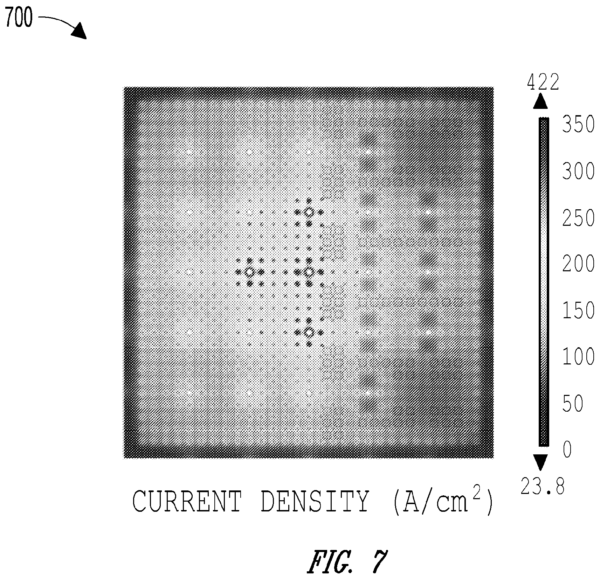

FIG. 7 illustrates, by way of example, a current density distribution heat map 700 from a device formed using the method illustrated in FIG. 6. As can be seen the current crowding in the center of the die is much higher near the opening in the dielectric material 674. This center peak luminance die has been obtained with a 0.1um thick bonding layer (n-type contact 670). An advantage of this method is that modification of n-vias density or modification of n-via size are not needed to achieve the luminance. It is worth noting that a level of increase in a peak magnitude and associated Vf increase of the example can be adjusted by modifying the bonding layer thickness.

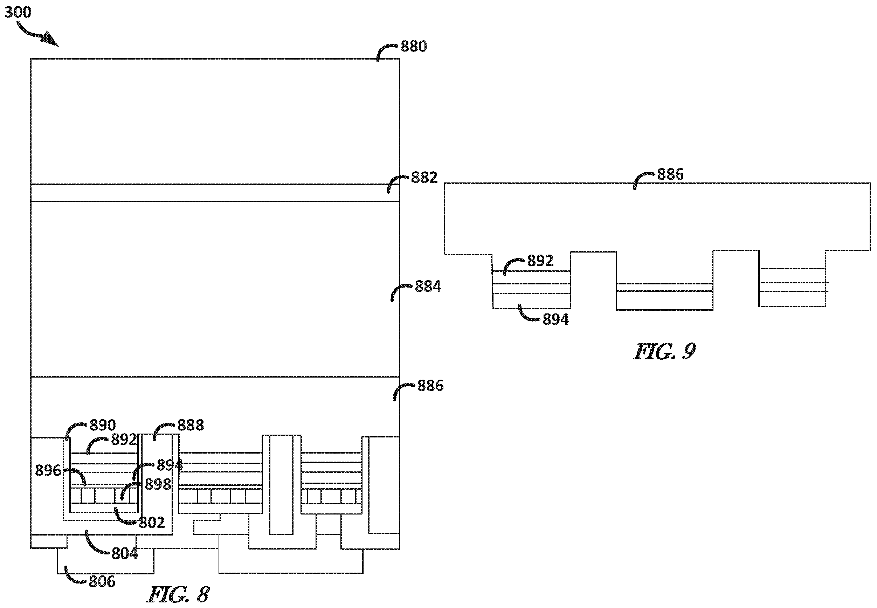

FIG. 8 illustrates, by way of example, a cross-section diagram of an embodiment of the light emitting apparatus 300. FIG. 9 illustrates, by way of example, an exploded view diagram of a portions of the cross-section illustrated in FIG. 8. The apparatus 300 as illustrated includes a phosphor converter 880 bonded to a sapphire structure 884 by an adhesive 882. The sapphire structure 884 is situated on a doped (e.g., n-doped) semiconductor material 886 (e.g., a gallium nitride (GaN)) semiconductor. The semiconductor material 886 is situated on the structure of FIG. 3. The structure includes a bonding layer 888, a dielectric layer 890 separating the bonding layer 888 from other structures, such as vias 898, ohmic contacts 896, a p-doped semiconductor material 894 (e.g., p-doped gallium nitride (GaN)), a quantum well (QW) 892, among others. A doped under-bump metallization (UBM) 806 is formed on the bonding layer 888. A silver and TiW material 802 is situated between the vias 898 and the dielectric 890.

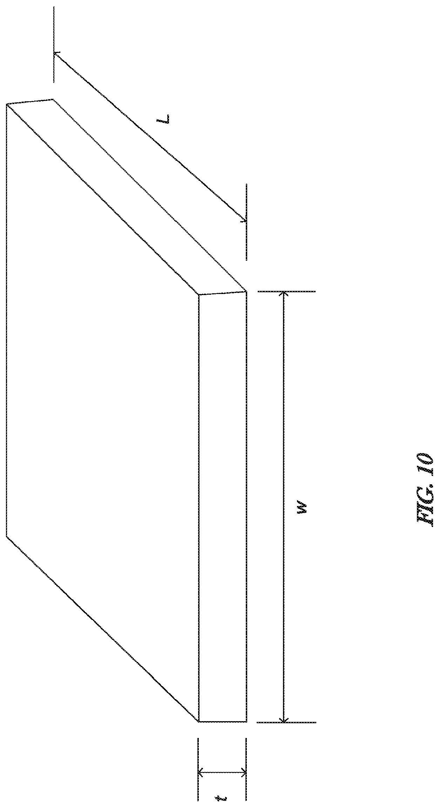

FIG. 10 illustrates, by way of example, a diagram that aids explanation of resistance per square (Rsq). *Resistance = ρL*/*wt* where *ρ* is the bulk resistivity in Ohm-meters, *L* is a length of the resistor, w is a width of the resistor, and t is a thickness of the resistor. *R_{sq} = ρ*/*t* . For example, *R_{sq}* = 0.1 *Ohms*/*sq* can be obtained with 0.265 um thickness Al with bulk resistivity =2.65 * 10^-8 Ohm meters. In another example, *R_{sq}* = 0.1 *Ohms*/*sq* can be obtained with 5 um thickness of TiW with bulk resistivity = 5 * 10^-7 Ohm meters.

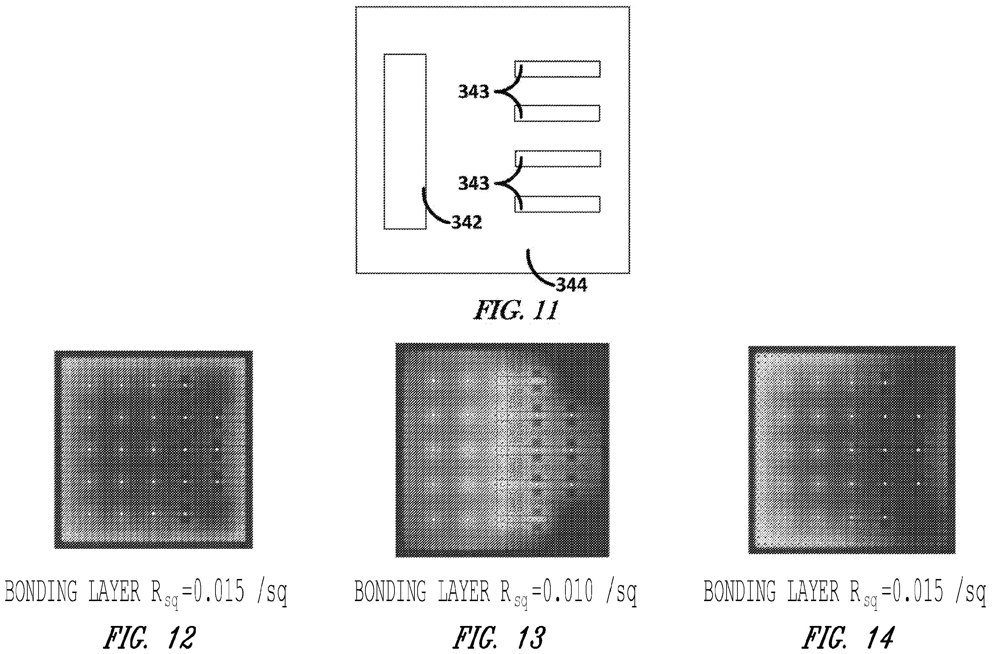

FIG. 11 illustrates, by way of example, a diagram of an embodiment of a portion of the apparatus 300. FIG. 12 illustrates, by way of example, a luminance diagram of the apparatus 300 with a bonding layer with a lower sheet resistance (a thicker bonding layer). FIG. 13 illustrates, by way of example, a luminance diagram of the apparatus 300 with a bonding layer with a sheet resistance of about 0.1 Ohms/sq (a thinner bonding layer). FIG. 14 illustrates, by way of example, a luminance diagram of the apparatus 300 with a bonding layer with a sheet resistance of about 0.15 Ohms/sq (an event thinner bonding layer).

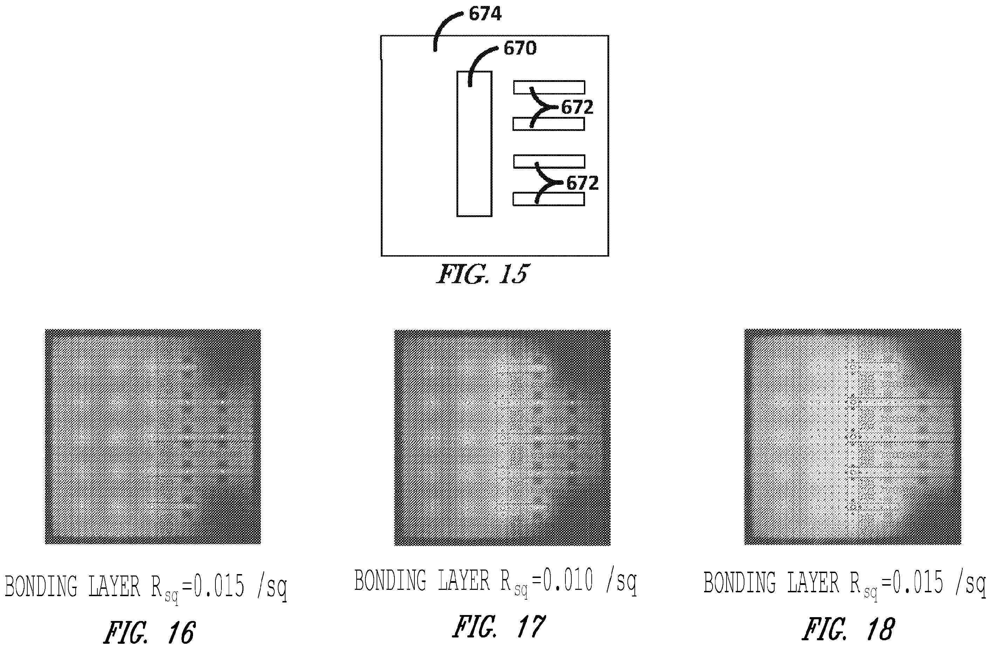

FIG. 15 illustrates, by way of example, a diagram of an embodiment of a portion of an apparatus that includes an opening for the n contact more central to the epitaxial layer than the opening illustrated in FIG. 11. FIG. 16 illustrates, by way of example, a luminance diagram of the apparatus of FIG. 15 with a bonding layer with a lower sheet resistance (a thicker bonding layer). FIG. 17 illustrates, by way of example, a luminance diagram of the apparatus of FIG. 15 with a bonding layer with a sheet resistance of about 0.1 Ohms/sq (a thinner bonding layer). FIG. 18 illustrates, by way of example, a luminance diagram of the apparatus of FIG. 15 with a bonding layer with a sheet resistance of about 0.15 Ohms/sq (an event thinner bonding layer).

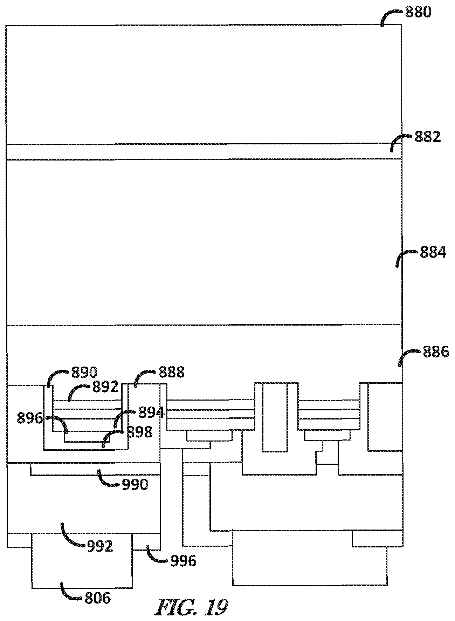

FIG. 19 illustrates, by way of example, a cross-section diagram of an embodiment of the apparatus 600. The apparatus includes three buildup layers (BLs) 890, 990, 996, the 3^{rd} BL 996 and the 2^{nd} BL 990 that are closer to the doped UBM 806 are thicker than the 1^{st} BL 890.

The die with adjustable light emitting area (either die 300 or 600) can be either VTF (vertical thin film or embedded contact vertical thin film), CSP (sapphire is still on the epi), or TFFC (Thin film flip chip). Areas within the die where n current is injected can have any shape: circle (n-via) but also long slot or any other shape.

The die 300, 600 can be built with standard manufacturing processes. Specific steps are to use dielectric layer with openings only near the target peak luminance area and limited bonding layer thickness.

In the case of 2 or more bonding layers, the dielectric layer separating the 2 bonding layers, the 1^{st} bonding layer will be thick enough to not have ohmic loss and 2^{nd} bonding layer will be thin to get ohmic loss in the area corresponding to the targeted luminance pattern. Finally, like for the case with 1 bonding layer, the dielectric layer situated between the electrical pads and 2^{nd} metal layer will have opening only near the peak current area.

For either of the LED dies 300, 600, the shaped luminance comes from an opening in the dielectric layer closest to the n-type contacts and p-type contacts that will be driven that is situated only near the peak current area and a bonding Layer (at least on the n-doped part) with Rsq > 0.1 Q/sq.

Shaped luminance profile die is defined as a die where the luminance averaged over an area equal to at least 10% of the whole light emitting area deviates more than 20% of the mean luminance averaged over the whole light emitting area.

Embodiments can be used in automotive headlamps or lighting device where a shaped (e.g., gradient or peaky) surface luminance is needed to get the best system performances.

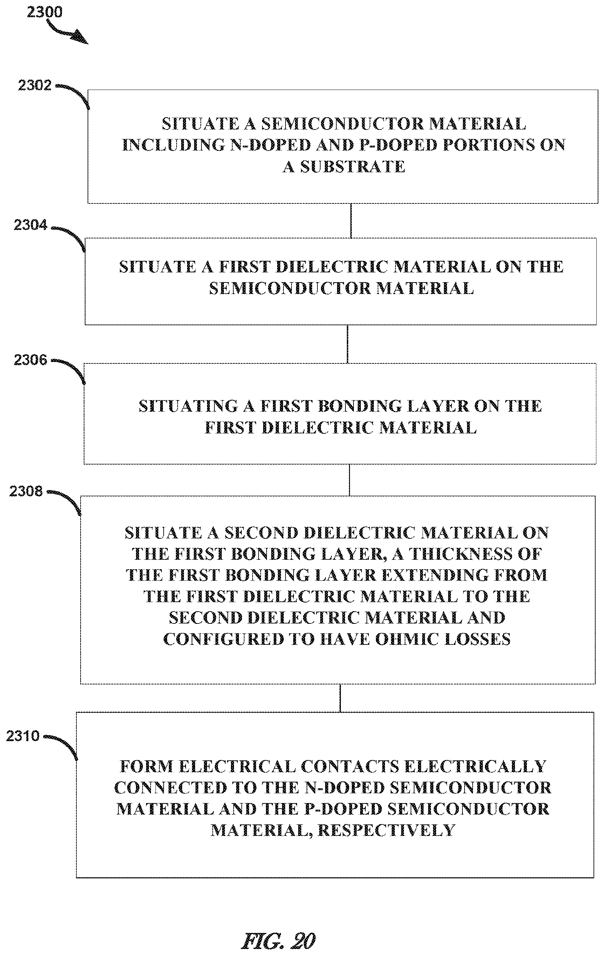

FIG. 20 illustrates, by way of example, a diagram of an embodiment of a method 2300 for making an LED device with controlled luminance. The method 2300 can be performed, at least in part, to create the device 300, 600, or other component, or a combination thereof. The method 2300, as illustrated, includes situating a semiconductor material including n-doped and p-doped portions on a substrate, at operation 2302; situating a first dielectric material on the semiconductor material, at operation 2304; situating a first bonding layer on the first dielectric material, at operation 2306; situating a second dielectric material on the first bonding layer, a thickness of the first bonding layer extending from the first dielectric material to the second dielectric material and configured to have ohmic losses, at operation 2308; and forming electrical contacts electrically connected to the n-doped semiconductor material and the p-doped semiconductor material, respectively, at operation 2310. The method 2300 can further include forming a hole in the second dielectric material through which an electrical contact of the electrical contacts is electrically connected to the first bonding layer, wherein the hole is sized, shaped, and located on the second dielectric material to configure a light pattern generated by the lighting apparatus.

Light emitting apparatuses, such as discussed herein, may support applications that benefit from fine-grained intensity, spatial, and temporal control of light distribution. This may include, but is not limited to, precise spatial patterning of emitted light. Depending on the application, emitted light may be spectrally distinct, adaptive over time, and/or environmentally responsive. The light emitting pixel arrays may provide pre-programmed light distribution in various intensity, spatial, or temporal patterns. Common applications supported by light emitting pixel arrays include video lighting, automotive headlights, architectural and area illumination, street lighting, and informational displays.

Light emitting apparatuses may be used to illuminate buildings or areas selectively and adaptively for improved visual display or to reduce lighting costs. In addition, light emitting apparatuses may be used to project media facades for decorative motion or video effects. In conjunction with tracking sensors and/or cameras, selective illumination of areas around pedestrians may be possible. Spectrally distinct pixels may be used to adjust the color temperature of lighting, as well as support wavelength specific horticultural illumination.

Street lighting is an application that may benefit from use of light emitting apparatuses. A single light emitting apparatus may be used to mimic various street light types, allowing, for example, switching between a Type I linear streetlight and a Type IV semicircular streetlight by appropriate activation or deactivation of selected pixels. In addition, street lighting costs may be lowered by adjusting light beam intensity or distribution according to environmental conditions or time of use. For example, light intensity and area of distribution may be reduced when pedestrians are not present.

Vehicle headlamps are a light emitting array application that requires large pixel numbers and a high data refresh rate. Automotive headlights that actively illuminate only selected sections of a roadway can used to reduce problems associated with glare or dazzling of oncoming drivers. Using infrared cameras as sensors, light emitting pixel arrays activate only those pixels needed to illuminate the roadway, while deactivating pixels that may dazzle pedestrians or drivers of oncoming vehicles. In addition, off-road pedestrians, animals, or signs may be selectively illuminated to improve driver environmental awareness. If pixels of the light emitting pixel array are spectrally distinct, the color temperature of the light may be adjusted according to respective daylight, twilight, or night conditions. Some pixels may be used for optical wireless vehicle to vehicle communication. An LED light module can include an apparatus, alone or in conjunction with primary or secondary optics, including lenses or reflectors.

While example embodiments of the present invention have been shown and described herein, it will be obvious to those skilled in the art that such embodiments are provided by way of example only. Numerous variations, changes, and substitutions will now occur to those skilled in the art, upon reading and understanding the material provided herein, without departing from the scope of the invention as defined by the claims. It should be understood that various alternatives to the embodiments of the invention described herein may be employed in practicing the various embodiments of the invention.

## Claims

1. A lighting apparatus comprising:
a p-doped semiconductor material (894);
an n-doped semiconductor material (886);
first and second dielectric materials (338, 344);
a bonding layer situated between the first and second dielectric materials, the bonding layer having a sheet resistance greater than 0.06 Ohms/sq; and
electrical contacts (342, 343) electrically connected to the n-doped semiconductor material and the p-doped semiconductor material.

2. The lighting apparatus of claim 1, wherein the bonding layer has a sheet resistance greater than 0.15 Ohms/sq.

3. The lighting apparatus of claim 1, further comprising a hole in the second dielectric material through which an electrical contact of the electrical contacts is electrically connected to the bonding layer.

4. The lighting apparatus of claim 3, wherein:
the hole is sized, shaped, and located on the second dielectric material to configure a light pattern generated by the lighting apparatus such that a footprint of the hole covers an area where surface luminance is at least higher than 70 % of a maximum luminance provided by the apparatus.

5. The lighting apparatus of claim 1, wherein the n-doped semiconductor material and p-doped semiconductor material include gallium nitride.

6. The lighting apparatus of claim 1, further comprising openings in the first and second dielectric materials, the openings within a footprint of an electrical contact of the electrical contacts.

7. The lighting apparatus of claim 1, further comprising:
a substrate (330); and
a contiguous, solid edge electrical contact (332) around the edge of the substrate.

8. The lighting apparatus of claim 7, further comprising:
n-vias (334) within the edge electrical contact.

9. The lighting apparatus of claim 8, wherein the n-vias are uniformly distributed within the edge electrical contact.

10. A lighting apparatus according to any of the preceding claims, further comprising:
a third dielectric material (674); and
a second bonding layer situated between the second dielectric material and the third dielectric material.

11. The lighting apparatus according to the preceding claim, further comprising:
a substrate (330); and
a segmented edge electrical contact (332) around the edge of the substrate.

12. The lighting apparatus according to the preceding claim, further comprising:
n-vias (334) within the edge electrical contact.

13. The lighting apparatus according to the preceding claim, wherein the n-vias are uniformly distributed within the edge electrical contact.

14. A method of making a lighting apparatus, the method comprising:
situating a semiconductor material including n-doped and p-doped portions on a substrate;
situating a first dielectric material on the semiconductor material;
situating a first bonding layer on the first dielectric material;
situating a second dielectric material on the first bonding layer, a thickness of the first bonding layer extending from the first dielectric material to the second dielectric material and having a sheet resistance greater than 0.06 Ohms/sq; and
forming electrical contacts electrically connected to the n-doped semiconductor material and the p-doped semiconductor material, respectively.

15. The method according to the preceding claim, further comprising forming a hole in the second dielectric material through which an electrical contact of the electrical contacts is electrically connected to the first bonding layer, wherein the hole is sized, shaped, and located on the second dielectric material to configure a light pattern generated by the lighting apparatus.

## Patentansprüche

1. Beleuchtungsvorrichtung, umfassend:
ein p-dotiertes Halbleitermaterial (894);
ein n-dotiertes Halbleitermaterial (886);
ein erstes und ein zweites dielektrisches Material (338, 344);
eine zwischen dem ersten und dem zweiten dielektrischen Material angeordnete Verbindungsschicht, wobei die Verbindungsschicht einen Flächenwiderstand von mehr als 0,06 Ohm/sq aufweist; und
elektrische Kontakte (342, 343), die elektrisch mit dem n-dotierten und dem p-dotierten Halbleitermaterial verbunden sind.

2. Die Beleuchtungsvorrichtung nach Anspruch 1, wobei die Verbindungsschicht einen Flächenwiderstand von mehr als 0,15 Ohm/sq aufweist.

3. Die Beleuchtungsvorrichtung nach Anspruch 1, die ferner ein Loch in dem zweiten dielektrischen Material umfasst, durch das ein elektrischer Kontakt der elektrischen Kontakte elektrisch mit der Verbindungsschicht verbunden ist.

4. Die Beleuchtungsvorrichtung nach Anspruch 3, wobei:
das Loch so dimensioniert, geformt und im zweiten dielektrischen Material angeordnet ist, dass es ein von der Beleuchtungsvorrichtung erzeugtes Lichtmuster so konfiguriert, dass die Grundfläche des Lochs einen Bereich abdeckt, in dem die Oberflächenleuchtdichte mindestens 70% der von der Vorrichtung bereitgestellten maximalen Leuchtdichte beträgt.

5. Die Beleuchtungsvorrichtung nach Anspruch 1, wobei das n-dotierte Halbleitermaterial und das p-dotierte Halbleitermaterial Galliumnitrid enthalten.

6. Die Beleuchtungsvorrichtung nach Anspruch 1, die ferner Öffnungen in dem ersten und dem zweiten dielektrischen Material umfasst, wobei sich die Öffnungen innerhalb der Grundfläche eines elektrischen Kontakts der elektrischen Kontakte befinden.

7. Die Beleuchtungsvorrichtung nach Anspruch 1, die ferner umfasst:
ein Substrat (330); und
einen zusammenhängenden, massiven Randkontakt (332) um den Rand des Substrats herum.

8. Die Beleuchtungsvorrichtung nach Anspruch 7, die ferner umfasst:
n-Vias (334) innerhalb des elektrischen Randkontakts.

9. Die Beleuchtungsvorrichtung nach Anspruch 8, wobei die n-Vias gleichmäßig innerhalb des elektrischen Randkontakts verteilt sind.

10. Beleuchtungsvorrichtung nach einem der vorstehenden Ansprüche, die ferner umfasst:
ein drittes dielektrisches Material (674); und
eine zweite Verbindungsschicht, die zwischen dem zweiten und dem dritten dielektrischen Material angeordnet ist.

11. Die Beleuchtungsvorrichtung nach dem vorstehenden Anspruch, die ferner umfasst:
ein Substrat (330); und
einen segmentierten elektrischen Randkontakt (332) um den Rand des Substrats herum.

12. Die Beleuchtungsvorrichtung nach dem vorstehenden Anspruch, die ferner umfasst:
n-Vias (334) innerhalb des elektrischen Randkontakts.

13. Beleuchtungsvorrichtung nach dem vorstehenden Anspruch, wobei die n-Vias gleichmäßig innerhalb des elektrischen Randkontakts verteilt sind.

14. Verfahren zur Herstellung einer Beleuchtungsvorrichtung, wobei das Verfahren umfasst:
Anordnen eines Halbleitermaterials, das n-dotierte und p-dotierte Bereiche auf einem Substrat enthält;
Anordnen eines ersten dielektrischen Materials auf dem Halbleitermaterial;
Anordnen einer ersten Verbindungsschicht auf dem ersten dielektrischen Material;
Anordnen eines zweiten dielektrischen Materials auf der ersten Verbindungsschicht, wobei sich die Dicke der ersten Verbindungsschicht vom ersten bis zum zweiten dielektrischen Material erstreckt und einen Flächenwiderstand von mehr als 0,06 Ohm/sq aufweist; und
Bilden elektrischer Kontakte, die jeweils elektrisch mit dem n-dotierten und dem p-dotierten Halbleitermaterial verbunden sind.

15. Verfahren nach dem vorstehenden Anspruch, das ferner das Ausbilden eines Lochs in dem zweiten dielektrischen Material umfasst, durch das ein elektrischer Kontakt der elektrischen Kontakte elektrisch mit der ersten Verbindungsschicht verbunden ist, wobei das Loch so dimensioniert, geformt und auf dem zweiten dielektrischen Material angeordnet ist, dass es ein von der Beleuchtungsvorrichtung erzeugtes Lichtmuster bildet.

## Revendications

1. Dispositif d'éclairage comprenant :
un matériau semi-conducteur dopé de type p (894) ;
un matériau semi-conducteur dopé de type n (886) ;
des premier et deuxième matériaux diélectriques (338, 344) ;
une couche de liaison située entre les premier et deuxième matériaux diélectriques, la couche de liaison présentant une résistance de surface supérieure à 0,06 ohm/sq ; et
des contacts électriques (342, 343) reliés électriquement au matériau semi-conducteur dopé de type n et au matériau semi-conducteur dopé de type p.

2. Dispositif d'éclairage selon la revendication 1, dans lequel la couche de liaison présente une résistance de surface supérieure à 0,15 ohm/sq.

3. Dispositif d'éclairage selon la revendication 1, comprenant en outre un trou dans le deuxième matériau diélectrique à travers lequel l'un des contacts électriques est relié électriquement à la couche de liaison.

4. Dispositif d'éclairage selon la revendication 3, dans lequel :
le trou est dimensionné, formé et situé sur le deuxième matériau diélectrique de manière à configurer un motif lumineux généré par le dispositif d'éclairage, de telle sorte que l'empreinte du trou couvre une zone où la luminance de surface est au moins supérieure à 70 % d'une luminance maximale fournie par le dispositif.

5. Dispositif d'éclairage selon la revendication 1, dans lequel le matériau semi-conducteur dopé de type n et le matériau semi-conducteur dopé de type p comprennent du nitrure de gallium.

6. Dispositif d'éclairage selon la revendication 1, comprenant en outre des ouvertures dans les premier et deuxième matériaux diélectriques, lesdites ouvertures se situant à l'intérieur de l'empreinte d'un contact électrique parmi lesdits contacts électriques.

7. Dispositif d'éclairage selon la revendication 1, comprenant en outre :
un substrat (330) ; et
un contact électrique solide et contigu (332) situé sur le pourtour du substrat.

8. Dispositif d'éclairage selon la revendication 7, comprenant en outre :
n vias (334) à l'intérieur du contact électrique périphérique.

9. Dispositif d'éclairage selon la revendication 8, dans lequel les n-vias sont répartis uniformément à l'intérieur du contact électrique périphérique.

10. Dispositif d'éclairage selon l'une quelconque des revendications précédentes, comprenant en outre :
un troisième matériau diélectrique (674) ; et
une deuxième couche de liaison située entre le deuxième matériau diélectrique et le troisième matériau diélectrique.

11. Dispositif d'éclairage selon la revendication précédente, comprenant en outre :
un substrat (330) ; et
un contact électrique segmenté (332) situé sur le pourtour du substrat.

12. Dispositif d'éclairage selon la revendication précédente, comprenant en outre :
n vias (334) à l'intérieur du contact électrique périphérique.

13. Dispositif d'éclairage selon la revendication précédente, dans lequel les n-vias sont répartis uniformément à l'intérieur du contact électrique périphérique.

14. Procédé de fabrication d'un dispositif d'éclairage, le procédé comprenant :
la mise en place d'un matériau semi-conducteur comprenant des parties dopées de type n et de type p sur un substrat ;
la mise en place d'un premier matériau diélectrique sur le matériau semi-conducteur ;
la mise en place d'une première couche de liaison sur le premier matériau diélectrique ;
la mise en place d'un deuxième matériau diélectrique sur la première couche de liaison, l'épaisseur de la première couche de liaison s'étendant du premier matériau diélectrique au deuxième matériau diélectrique et présentant une résistance de feuille supérieure à 0,06 ohm/sq ; et
la formation de contacts électriques reliés électriquement, respectivement, au matériau semi-conducteur dopé de type n et au matériau semi-conducteur dopé de type p.

15. Procédé selon la revendication précédente, comprenant en outre la formation d'un trou dans le deuxième matériau diélectrique à travers lequel l'un des contacts électriques est relié électriquement à la première couche de liaison, le trou étant dimensionné, formé et situé sur le deuxième matériau diélectrique de manière à configurer un motif lumineux généré par le dispositif d'éclairage.
